# EUROPEAN PATENT APPLICATION

(11) **EP 4 418 829 A1**
(43) Date of publication of application: **21.08.2024**
(21) Application number: 24156467.3
(22) Date of filing: 08.02.2024
(51) Int. Cl.: H05K 7/14

(54) **MODULAR DATA CENTER SYSTEM**

(30) Priority: 15.02.2023 US 202363445827 P; 20.06.2023 US 202363522035 P; 17.01.2024 US 202418414639
(71) Applicant: Vertiv Corporation, Westerville, OH 43082 (US)
(72) Inventor: Brzic, Vedran, Zagreb (HR); Jelicic, Jelena, Zagreb (HR)
(74) Representative: Algemeen Octrooi- en Merkenbureau B.V.

(57) **Abstract**

A modular data center system may include a first sidewall including a first set of framing members of the plurality of framing members, a second sidewall including a second set of framing members of the plurality of framing members, a third sidewall including a third set of framing members of the plurality of framing members, a fourth sidewall including a fourth set of framing members of the plurality of framing members, a fifth sidewall including a fifth set of framing members of the plurality of framing members, and a sixth sidewall including a sixth set of framing members of the plurality of framing members. The modular data center system may include one or more sidewall panels configured to couple to at least one framing member of the plurality of sidewalls, where the plurality of framing members are formed of a timber material.

## Description

### TECHNICAL FIELD

The present invention generally relates to the field of data centers, and more particularly, to a modular data center system formed of a low carbon footprint material.

### BACKGROUND

Modular data centers are often portable enclosures (or buildings) used to house data center infrastructure, information technology (IT) equipment, and power equipment and used to deploy data center capacity wherever capacity is needed. These data centers are often constructed of steel or concrete. Such materials are heavy and have a high carbon footprint. As sustainability becomes increasingly more important when designing such data centers, there is a need for a system or method to provide a low carbon footprint design to reduce the total amount of greenhouse gases.

### SUMMARY

According to a first aspect, the present invention relates to a modular data center system is disclosed, in accordance with one or more embodiments of the present disclosure. In embodiments, the modular data center system includes a plurality of sidewalls including a plurality of framing members. The plurality of sidewalls define a cavity configured to house one or more pieces of data center equipment, where the plurality of framing members include at least one of one or more vertical framing members or one or more horizontal framing members. The plurality of sidewalls include a first sidewall including a first set of framing members of the plurality of framing members; a second sidewall including a second set of framing members of the plurality of framing members; a third sidewall including a third set of framing members of the plurality of framing members; a fourth sidewall including a fourth set of framing members of the plurality of framing members; a fifth sidewall including a fifth set of framing members of the plurality of framing members; and a sixth sidewall including a sixth set of framing members of the plurality of framing members. The modular data center system includes one or more sidewall panels configured to couple to at least one framing member of the plurality of sidewalls, where the plurality of framing members may be formed of a timber material.

According a second aspect, the present invention relates to a modular data center system. The modular data center system includes a plurality of sidewalls including a plurality of framing members. The plurality of sidewalls define a cavity configured to house one or more pieces of equipment. In embodiments, the plurality of sidewalls includes a first sidewall including a first set of framing members; a second sidewall including a second set of framing members; a third sidewall including a third set of framing members; a fourth sidewall including a fourth set of framing members; a fifth sidewall including a fifth set of framing members; a sixth sidewall including a sixth set of framing members. The modular data center system includes the plurality of framing members including one of one or more vertical framing members, one or more diagonal framing members, or one or more horizontal framing members. The modular data center system includes one or more floor panels configured to couple to at least one framing member of the plurality of sidewalls.

According to a third aspect, the invention relates to a modular data center system. The modular data center system includes a plurality of framing members including one of one or more vertical framing members, one or more diagonal framing members, or one or more horizontal framing members. In embodiments, the modular data center system includes one or more floor panels configured to couple to at least one framing member of the plurality of framing members to define a cavity, where the one or more floor panels are configured to support one or more pieces of equipment.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A is a perspective view of a modular data center system, in accordance with the present invention..
FIG. 1B is a cross-sectional view of a modular data center system, in accordance with the present invention.
FIG. 1C is a cross-sectional view of a modular data center system, in accordance with the present invention.
FIG. 1D is a perspective view of a frame of the modular data center system, in accordance with the present invention.
FIG. 2A is a perspective view of a frame of the modular data center system, in accordance with the present invention.
FIG. 2B is a perspective view of a frame of the modular data center system, in accordance with the present invention.
FIG. 2C is a perspective view of a frame of the modular data center system, in accordance with the present invention.
FIG. 2D is a perspective view of a frame of the modular data center system, in accordance with the present invention.
FIG. 2E is a top view of a frame of the modular data center system, in accordance with the present invention.
FIG. 2F is a top view of a frame of the modular data center system, in accordance with the present invention.
FIG. 3 is a perspective view of a modular data center system, in accordance with the present invention.
FIG. 4A is a perspective view of a side panel of the modular data center system, in accordance with the present invention.
FIG. 4B is a perspective view of a side panel of the modular data center system, in accordance with the present invention.
FIG. 5A is a top view of a modular data center system, in accordance with the present invention.
FIG. 5B is a side view of a modular data center system, in accordance with the present invention.
FIG. 6A is a top view of a modular data center system, in accordance with the present invention. FIG. 6B is a side view of a modular data center system, in accordance with the present invention.
FIG. 7 is a perspective view of a modular data center system, in accordance with the present invention.
FIG. 8A is a perspective view of a modular data center system, in accordance with the present invention.
FIG. 8B is a perspective view of a modular data center system, in accordance with the present invention.

### DETAILED DESCRIPTION

Reference will now be made in detail to the subject matter disclosed, which is illustrated in the accompanying drawings.

Modular data centers are often portable enclosures (or buildings) used to house data center infrastructure, IT equipment, and power equipment and used to deploy data center capacity wherever capacity is needed. These data centers are often constructed of steel or concrete. Such materials are heavy and have a high carbon footprint. As sustainability becomes increasingly more important when designing such data centers, there is a need for a system or method to provide a low carbon footprint design to reduce the total amount of greenhouse gases.

Accordingly, the present invention is directed to a data center system. More particularly, the present invention is directed to a data center system constructed of a low carbon footprint material (e.g., wood/timber, laminated materials, cross-laminated materials, and the like). For example, the data center system of the present invention includes a plurality of frame members formed of a low carbon footprint material. Further, the data center of the present invention includes a plurality of panel members coupled to the plurality of frame members, where the plurality of panel members are also formed of a low carbon footprint material.

It is contemplated herein that a low carbon footprint material such as wood/timber provides several advantages over conventional alternatives such as steel and concrete. For example, timber may be considered an environmentally sustainable building material and may be renewable if harvested using sustainable processes. By way of another example, timber also stores carbon dioxide captured from the environment. As a result, timber construction can have less carbon footprint, can minimize resource depletion, and can function as a form of carbon removal when combined with sustainable timber production and sustainable building demolition practices. By way of another example, timber has great mechanical properties (e.g., high tensile strength, high pressure strength, seismic resistance) and timber structure, if designed according to applicable building codes and standards, provides robust performance in the face of seismic activity, wind forces, snow loads and structural demands. By way of another example, timber is a natural insulator. By way timber structure can be designed to meet building code requirements for fire design.

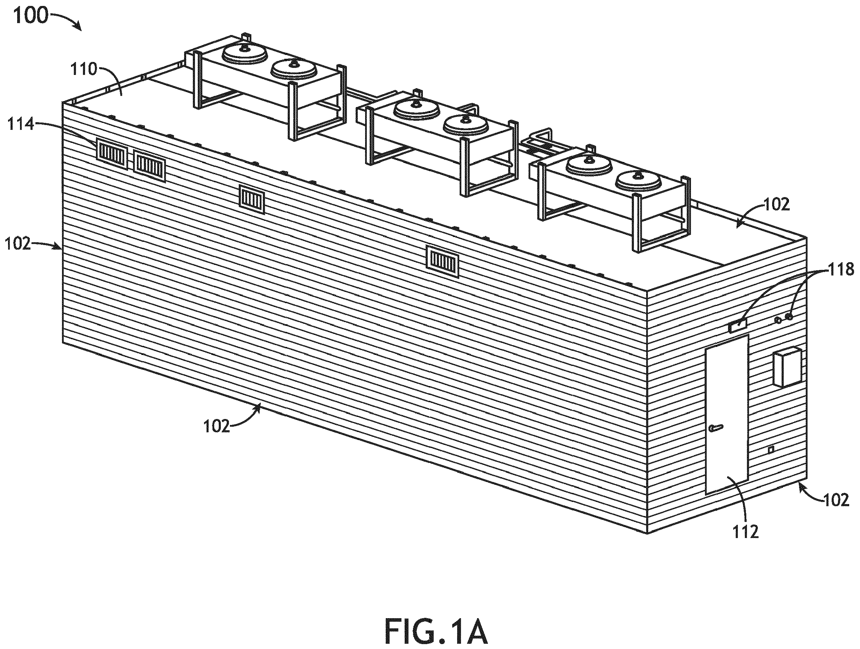

FIGS. 1A-1D illustrate a modular data center system 100 of the present invention is shown. For purposes of the present invention, the term "modular data center system 100", "data center system 100", "modular system 100", "system 100", and variations thereof may be considered equivalent, unless otherwise noted herein.

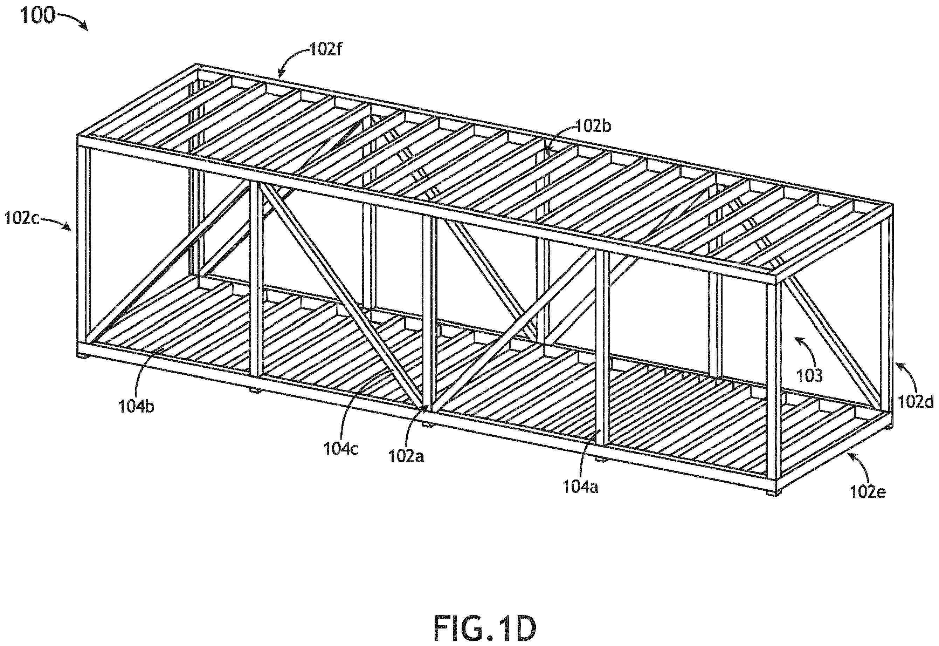

The system 100 includes a plurality of sidewalls 102. The system 100 includes at least a first sidewall 102a, a second sidewall 102b, a third sidewall 102c, a fourth sidewall 102d, a fifth sidewall 102e, and a sixth sidewall 102f. For instance, as shown in FIG. 1D, the system 100 may include a left sidewall 102a, a right sidewall 102b, a rear sidewall 102c, a front sidewall 102d, a bottom sidewall 102e, and a top sidewall 102f.

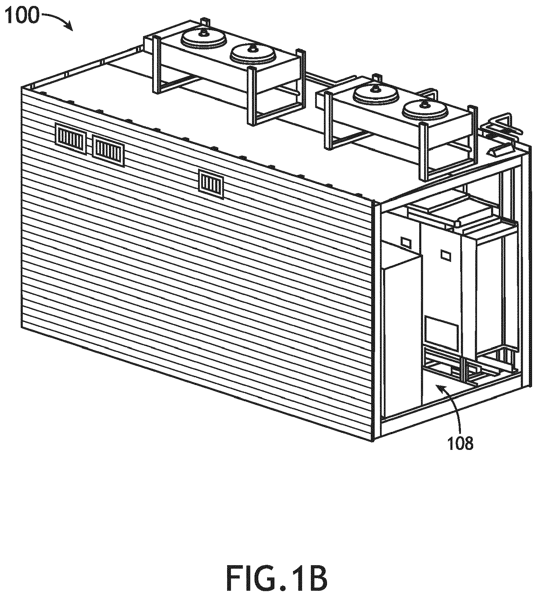

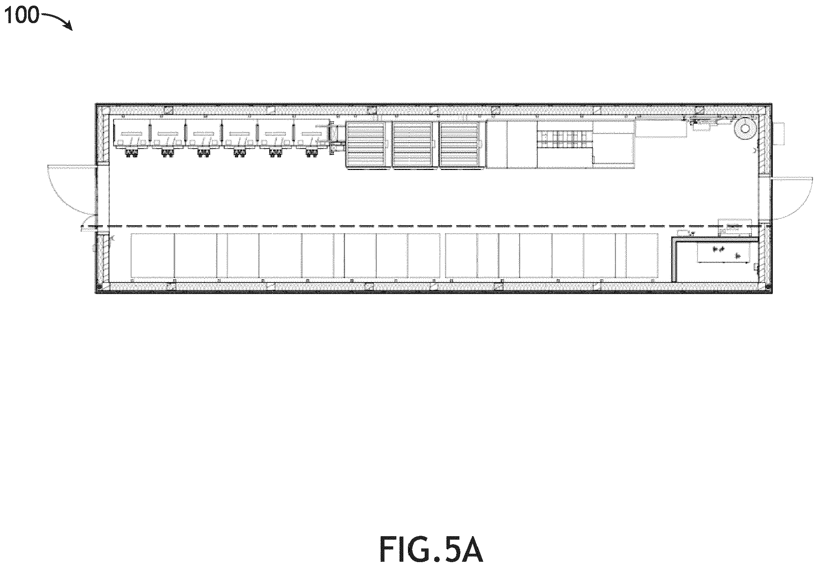

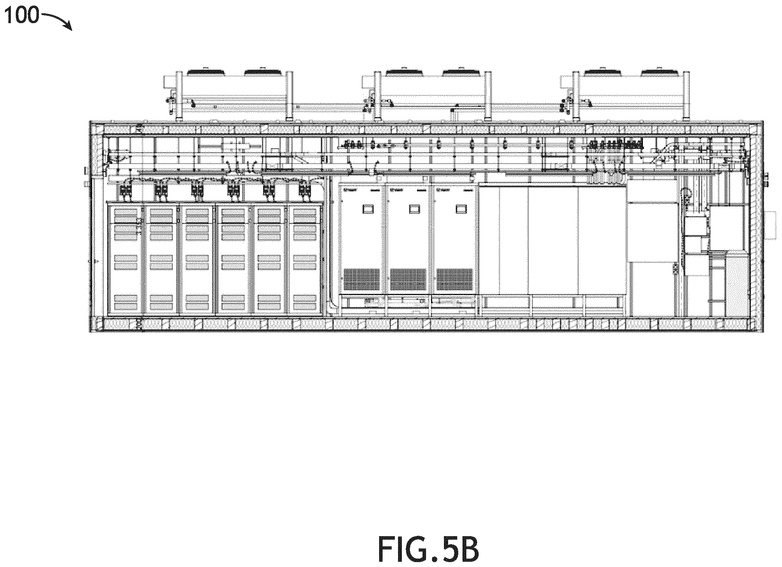

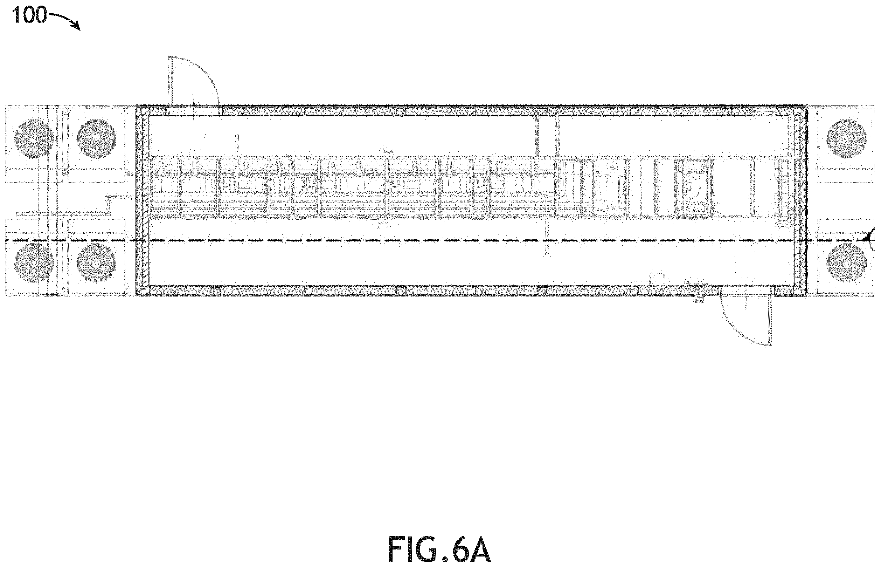

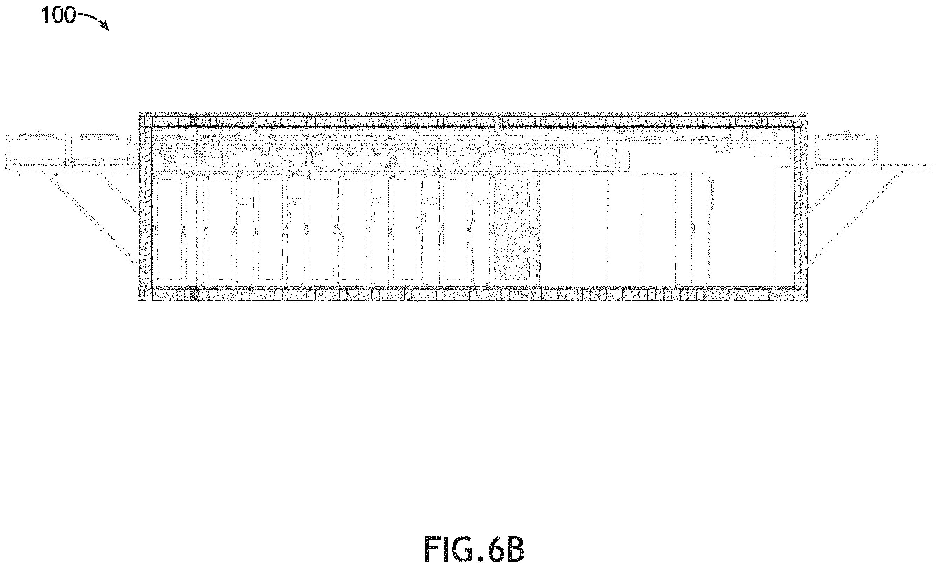

The plurality of sidewalls 102 defines at least one cavity 103 configured to house one or more pieces of equipment, as shown in FIG. 1B. As shown in FIG. 5A-5B, the cavity 103 is configured to house one or more pieces of power equipment including, for example, but not limited to, one or more transformers, one or more switchboards (e.g., medium voltage (MV) switchboards, low voltage (LV) switchboards, and the like), one or more uninterruptible power supplies (UPSs), one or more batteries, one or more air conditioning units, one or more liquid cooling units, one or more fuel cells, one or more electrolysers, one or more power converters, and the like. By way of another example, as shown in FIG. 6A-6B, the cavity 103 may be configured to house data infrastructure and IT equipment including, but not limited to, LV switchboards, MV switchboards, UPS, one or more batteries, one or more air conditioning units, one or more liquid cooling units, one or more server racks, one or more cable trays, one or more fiber trays, and the like.

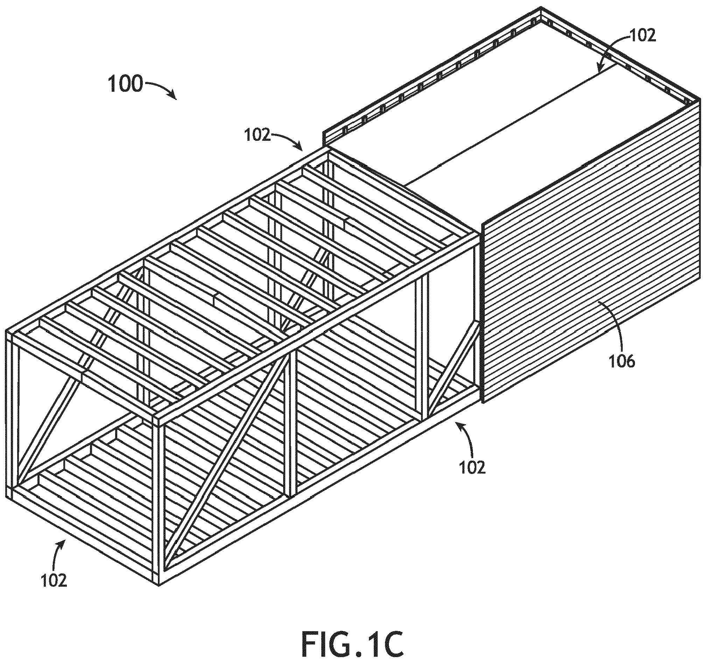

In embodiments, as shown in FIG. 1C, each sidewall 102 may be formed by one or more framing members 104. For example, each sidewall 102 may be formed of at least one of one or more vertical framing members 104a or one or more horizontal framing members 104b. By way of another example, each sidewall 102 may be formed of one or more diagonal framing members 104c.

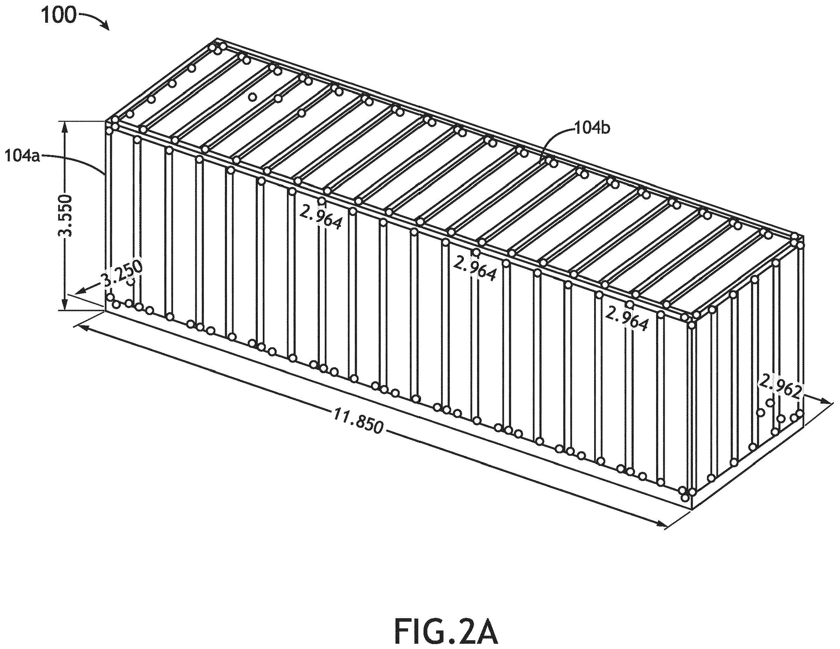

FIGS. 2A-2F illustrate framing members 104 of the modular data center system 100, in accordance with one or more embodiments of the present disclosure. Although FIGS. 1D-2D depicts a specific configuration of framing members 104 (e.g., number, arrangement, or the like), it is noted that the system 100 may include any number and configuration of framing members.

In embodiments, the system 100 may include two or more vertical framing members 104a and two or more horizontal framing members 104b.

For example, in a non-limiting example, as shown in FIG. 1D, the first sidewall 102a (e.g., the left sidewall 102a) may be formed of the one vertical framing members 104a, the one or more diagonal framing members 104c, and the one or more horizontal framing members 104b. For instance, the first sidewall 102a may include five vertical framing members 104a, three diagonal framing members 104c, and two horizontal framing member 104b (e.g., a top horizontal framing member and a bottom horizontal framing member). By way of another example, in a non-limiting example, as shown in FIG. 1D, the second sidewall 102b (e.g., the right sidewall 102b) may be formed of the one vertical framing members 104a, the one or more diagonal framing members 104c, and the one or more horizontal framing members 104b. For instance, the second sidewall 102b may include five vertical framing members 104a, three diagonal framing members 104c, and two horizontal framing members 104b (e.g., a top horizontal framing member and a bottom horizontal framing member). By way of another example, in a non-limiting example, as shown in FIG. 1D, the third sidewall 102c (e.g., the rear sidewall 102c) may be formed of the one or more vertical framing members 104a and the one or more horizontal framing members 104b. For instance, the third sidewall 102c may include two vertical framing members 104a and two horizontal framing members 104b (e.g., a top horizontal framing member and a bottom horizontal framing member). By way of another example, in a non-limiting example, as shown in FIG. 1D, the fourth sidewall 102d (e.g., the front sidewall 102d) may be formed of the one vertical framing members 104a and the one or more horizontal framing members 104b. For instance, the third sidewall 102c may include two vertical framing members 104a and two horizontal framing members 104b (e.g., a top horizontal framing member and a bottom horizontal framing member). By way of another example, in a non-limiting example, as shown in FIG. 1D, the fifth sidewall 102e (e.g., the bottom sidewall 102e) may be formed of the one vertical framing members 104a and the one or more horizontal framing members 104b. For instance, the fifth sidewall 102e may include twenty-four vertical framing members 104a and two horizontal framing members 104b (e.g., a left side horizontal framing member and a right-side horizontal framing member). By way of another example, in a non-limiting example, as shown in FIG. 1D, the sixth sidewall 102f (e.g., the top sidewall 102f) may be formed of the one vertical framing members 104a and the one or more horizontal framing members 104b. For instance, the sixth sidewall 102e may include twenty-one vertical framing members 104a and two horizontal framing members 104b (e.g., a left side horizontal framing member and a right side horizontal framing member).

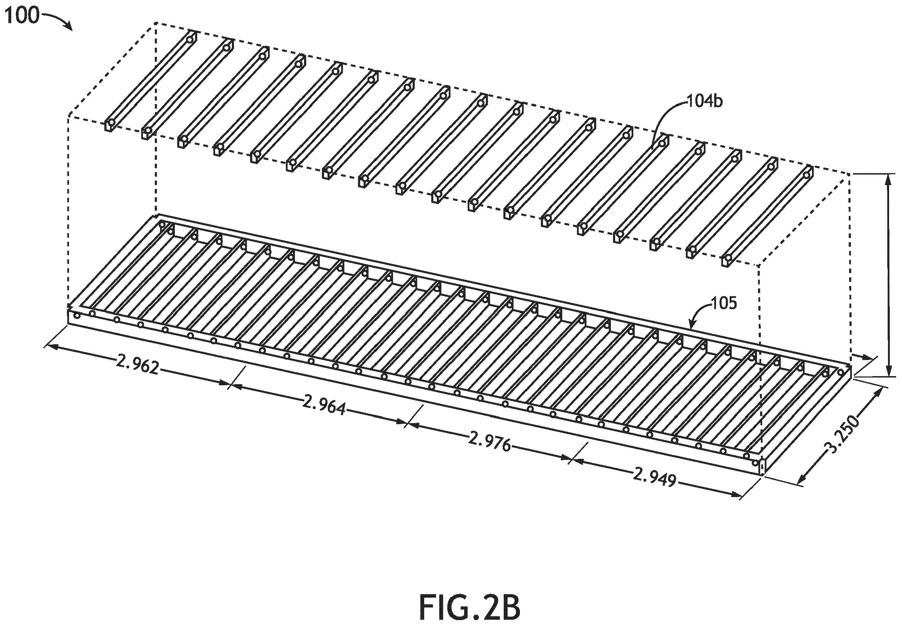

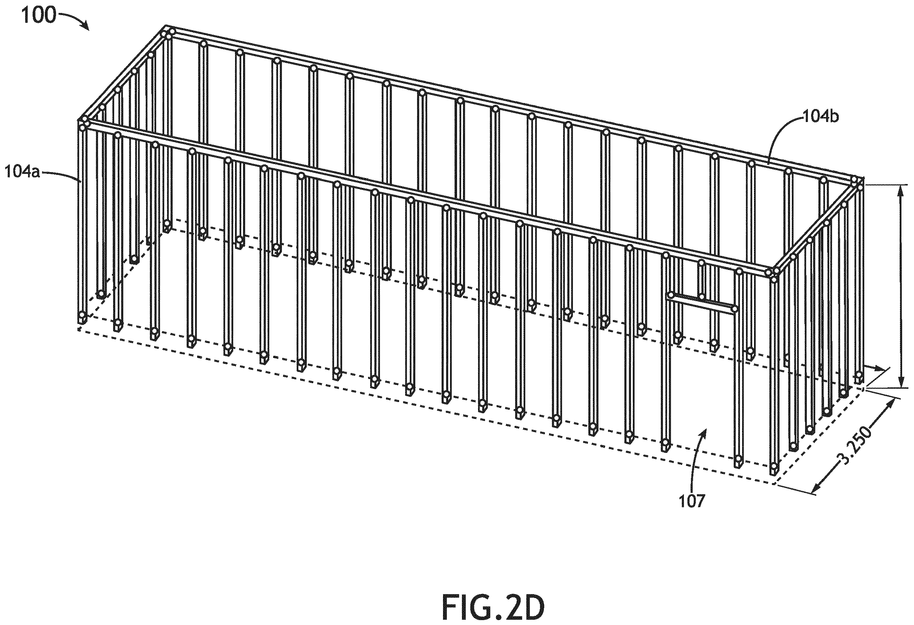

In an additional non-limiting example, as shown in FIG. 2A, the first sidewall 102a (e.g., the left sidewall 102a) and the second sidewall 102b (e.g., the right sidewall 102b) may be formed of the one vertical framing members 104a and the one or more horizontal framing members 104b. For instance, the first sidewall 102a and second sidewall 102b may each include twenty vertical framing members 104a and two horizontal framing members 104b (e.g., a top horizontal framing member and a bottom horizontal framing member). In some instances, as shown in FIG. 2D, the first sidewall 102a (or second sidewall 102b) may include a door frame 107, such that the sidewall 102a may include one or more horizontal and vertical framing members forming the door frame 107. By way of another example, in a non-limiting example, as shown in FIG. 2A, the third sidewall 102c (e.g., the rear sidewall 102c) and the fourth sidewall 102d (e.g., the front sidewall 102d) may be formed of the one or more vertical framing members 104a and the one or more horizontal framing members 104b. For instance, the third sidewall 102c and the fourth sidewall 102d may each include six vertical framing members 104a and two horizontal framing members 104b (e.g., a top horizontal framing member and a bottom horizontal framing member). By way of another example, in a non-limiting example, as shown in FIG. 2B, the fifth sidewall 102e (e.g., the bottom sidewall 102e) may be formed of the one or more horizontal framing members 104b. For instance, the fifth sidewall 102e may include twenty-eight horizontal framing members 104b. By way of another example, in a non-limiting example, as shown in FIG. 2B, the sixth sidewall 102f (e.g., the top sidewall 102f) may be formed of the one horizontal framing members 104b. For instance, the sixth sidewall 102f may include twenty horizontal framing members 104b.

It is noted that the one or more sidewalls 102 may share one or more framing members. For example, the third sidewall 102c (e.g., the rear sidewall 102c) may share one or more framing members 104 with at least one of the first sidewall 102a (e.g., the left sidewall 102), the second sidewall 102b (e.g., the right sidewall 102b), the fifth sidewall 102e (e.g., the bottom sidewall 102e), and the sixth sidewall 102f (e.g., the top sidewall 102f). By way of another example, the fourth sidewall 102d (e.g., the front sidewall 102d) may share one or more framing members 104 with at least one of the first sidewall 102a (e.g., the left sidewall 102), the second sidewall 102b (e.g., the right sidewall 102b), the fifth sidewall 102e (e.g., the bottom sidewall 102e), and the sixth sidewall 102f (e.g., the top sidewall 102f).

Further, it is noted herein that a single framing member 104 may define at least one or more portions of the plurality of sidewalls 102. For example, as shown in FIG. 1D, the single framing member 104 may be a 3-sided framing member that defines at least a portion of the first sidewall 102a (e.g., the left sidewall 102a), the second sidewall 102b (e.g., the right sidewall 102b), and the sixth sidewall 102f (e.g., the top sidewall 102f). In some embodiments, the plurality of frame members 104 are a single-piece. For example, as shown in FIG. 2B, the bottom sidewall 102e may include a base frame member that defines a bottom perimeter of the bottom sidewall 102e, where the base frame member 105 is coupled to the individual horizontal framing members 104b (e.g., twenty-eight horizontal framing members 104b). By way of another example, the top sidewall 102f may include a top frame member that defines a top perimeter of the top sidewall 102f, where the top frame member may be coupled to the individual horizontal framing members 104b.

In a non-limiting example, as shown in FIGS. 2A-2D, the length of the modular data center system 100 may be 11.850 m, the height of the modular data center system 100 may be 3.550 m, and the width of the modular data center 100 may be 3.250 m. For instance, in a non-limiting example, each framing member 104 may be spaced approximately 0.5 m. Although FIGS. 2A-2E depict the framing members 104 being substantially evenly spaced, it is contemplated herein that the spacing and/or configuration of the framing members 104 may be adjusted based on the needs of data center floor and/or the equipment used within the system 100.

It is noted that the one or more framing members 104 may be any size and/or shape. For example, the one or more framing members 104 may have a b/h between 10 cm - 20 cm. In one instance, the one or more framing members 104 may have a b/h of 10/14 cm. In another instance, the one or more framing members 104 may have a b/h of 12/12 cm. In another instance, the one or more framing members 104 may have a b/h of 14/14 cm. In another instance, the one or more framing members 104 may have a b/h of 14/16 cm. In another instance, the one or more framing members 104 may have a b/h of 14/20 cm.

The one or more framing members 104 may be formed of one or more low carbon footprint materials suitable for providing thermal and fire protection. For example, the one or more framing members 104 may be formed of a timber material (e.g., a wood material that is suitable for construction). In one instance, the timber material may incorporate, in whole or in part, any suitable wood material (e.g., a material derived from a tree, bamboo, or another woody plant). In another instance, the timber material may incorporate, in whole or in part, a timber-based composite. In another instance, the timber material may incorporate, in whole or in part, any cut timber (or sawn timber).

In a non-limiting example, the timber material may include a softwood timber such as, but not limited to, sprue, cedar, fir, pine, redwood, hemlock, and the like. In an additional non-limiting example, the timber material may be a hardwood timber such as, but is not limited to, poplar timber, teakwood, oakwood, rosewood, Maplewood, Ashwood, and the like. In a non-limiting example, the timber material may be a cross-laminated timber (CLT). In another non-limiting example, the timber material may be a laminated timber. In another non-limiting example, the timber material may be an oriented stand board (OSB).

In some embodiments, the horizontal framing members 104b of the top sidewall 102f may formed of one of poplar or softwood timber. In some embodiments, the base frame member of the bottom sidewall 102e may be formed of glulam timber and the horizontal framing members 104b of the bottom sidewall 102e may be formed of poplar or softwood timber. In some embodiments, the vertical framing members 104a of the one or more sidewalls 102 (e.g., left sidewall 102a, right sidewall 102b, rear sidewall 102c, and/or the front sidewall 102d) may be formed of poplar or softwood timber. In some embodiments, the top frame member of the top sidewall 102f may be formed of poplar or softwood timber.

It is contemplated herein that the structural integrity of the modular data center system 100 must pass structural testing, such that the individual frame members 104 of the system 100 are able to remain intact through the full process (e.g., manufacturing, installation, testing/experimentation, delivery, usage, and the like).

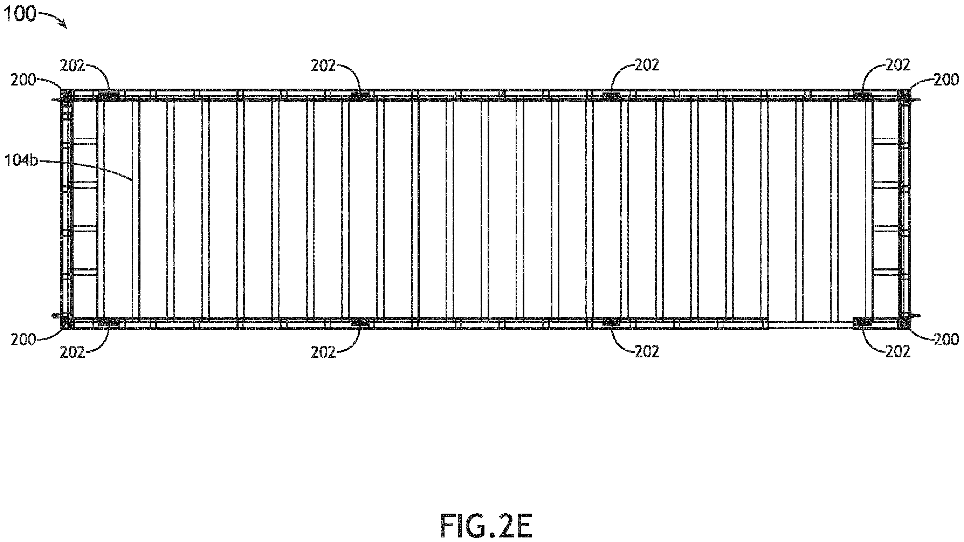

Referring to FIGS. 2E-2F, the modular data center system 100 may include one or more support columns 200 configured to provide foundational support at one or more locations. For example, the one or more support columns 200 may be one or more vertical framing members 104a configured to provide wall column support for the system 100. For instance, as shown in FIG. 2E, the one or more support columns 200 may be arranged at the four corners of the system 100.

The modular data center system 100 may include one or more tension rods 202. For example, as shown in FIG. 2E, the left sidewall 102a and the right sidewall 102b may include a plurality tension rods 202 arranged proximate to the one or more framing members 104. In this regard, the tension rods 202 may take over the tensile force when lifting.

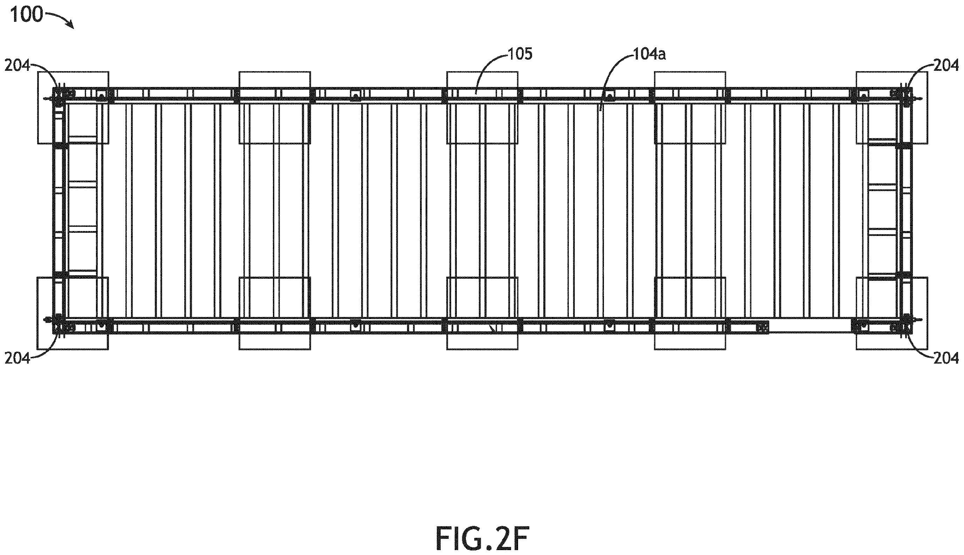

The modular data center system 100 may include one or more hold-down anchor brackets 204. For example, as shown in FIG. 2F, the one or more hold-down anchor brackets 204 may be arranged at the four corners of the system 100. The one or more brackets 204 may be used to coupled the respective framing members 104 together.

It is contemplated herein that the one or more framing members 104 may be fastened together via any mechanism such as, but not limited to, one or more mechanical fasteners (e.g., screws, bolts, nuts, washers, brackets, or the like), one or more adhesive fasteners (e.g., glue, or the like), one or more welding processes, or the like.

In some embodiments, the modular data center system 100 may include one or more support plates. For example, the modular data center system 100 may include one or more metal support plates (e.g., steel, or the like) configured to provide additional support along the sidewalls 102. In one instance, the one or more metal support plates may be coupled to an exterior surface of a sidewall panel 106. In another instance, the one or more metal support plates may be coupled to an interior surface (e.g., between framing member 104 and exterior panels 106, framing member and interior panels, within the sidewall panels themselves, or the like.

Referring back to FIGS. 1A-1C, the one or more framing members 104 may be configured to couple to one or more sidewall panels 106. For example, as shown in FIG. 1C, each sidewall 102 may include one or more sidewall panels 106 coupled to one or more portions of the one or more framing members 104. In one instance, the first sidewall 102a (e.g., the left sidewall 102a) may couple to a first sidewall panel 106 (e.g., a left sidewall panel 106). In another instance, the second sidewall 102b (e.g., the right sidewall 102b) may couple to a second sidewall panel 106 (e.g., a right sidewall panel 106). In another instance, the third sidewall 102c (e.g., the rear sidewall 102c) may couple to a third sidewall panel 106 (e.g., a rear sidewall panel 106). In another instance, the fourth sidewall 102d (e.g., front sidewall 102) may couple to a fourth sidewall panel 106 (e.g., a front sidewall panel 106).

In some embodiments, as shown in FIGS. 1A-1C, the one or more sidewall panels 106 include a single panel. For example, each sidewall 102 may coupled to a respective single panel.

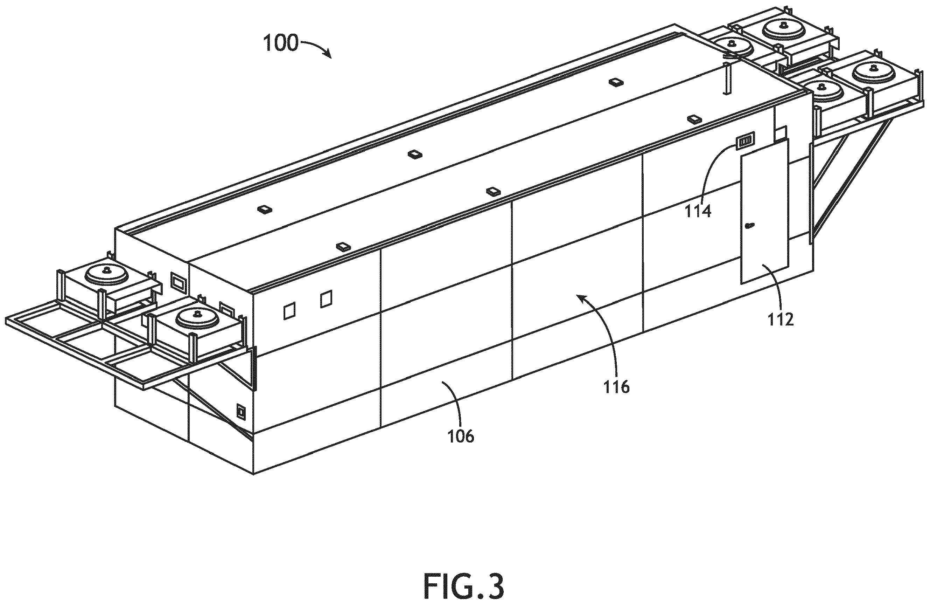

In some embodiments, as shown in FIG. 3, the one or more sidewall panels 106 may include a set of a plurality of panels. For example, each sidewall 102 may be coupled to a respective set of a plurality of panels.

The one or more framing members 104 may be further configured to couple to a floor panel 108. For example, as shown in FIG. 1B, the bottom sidewall 102e may be configured to couple to a floor panel 108. For instance, the floor panel 108 may be configured to couple to the one or more framing members 104 of the bottom sidewall 102e. In this regard, the floor panel 108 may be configured to support the one or more pieces of equipment within the cavity 103.

The one or more framing members 104 may be further configured to couple to a roof panel 110. For example, as shown in FIGS. 1A-1C, the top sidewall 102f may be configured to couple to a roof panel 110. For instance, the roof panel 110 may be configured to couple to the one or more framing members 104 of the top sidewall 102f. In this regard, the roof panel 110 may be configured to support the one or more pieces of equipment (e.g., one or more fans/AC units, and the like) stored on the roof of the system 100.

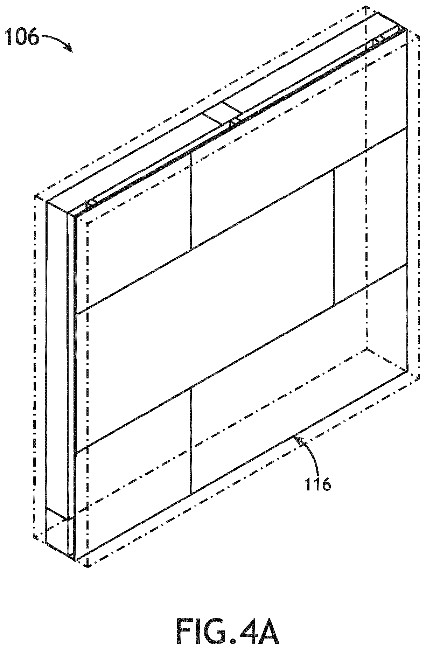

Referring to FIGS. 4A-4B, the one or more panels 106-110 may be formed of one or more layers. For example, the one or more panels 106-110 may be formed of one or more layers, where the one or more layers have a fire resistance between approximately 0 and 120 min and have a thermal transmittance factor, u, approximately less than 0.5 W/m²K). It is contemplated herein that fire resistance and thermal transmittance is important to ensure that the electronic equipment within the system 100 is stored/handled properly.

The one or more layers may be formed any suitable material such as, but not limited to, PVC foil, OSB board, wooden cladding, gypsum board, mineral wool, timber, air layer/cladding, waterproof plywood, or the like. The thickness of each layer may be any thickness. For example, a respective layer may be between 2 mm - 250 mm.

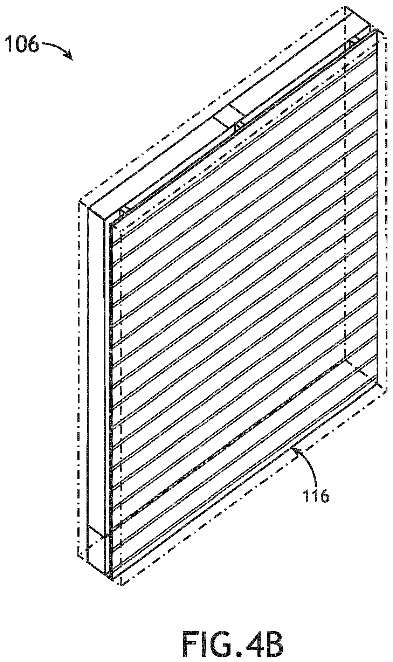

The one or more sidewall panels 106 may include a façade 116. For example, as shown in FIG. 4A, the one or more sidewall panels 106 may include a timber plate (e.g., thermowood) façade. By way of another example, as shown in FIG. 4B, the one or more sidewall panels 106 may include a rock panel cladding board façade.

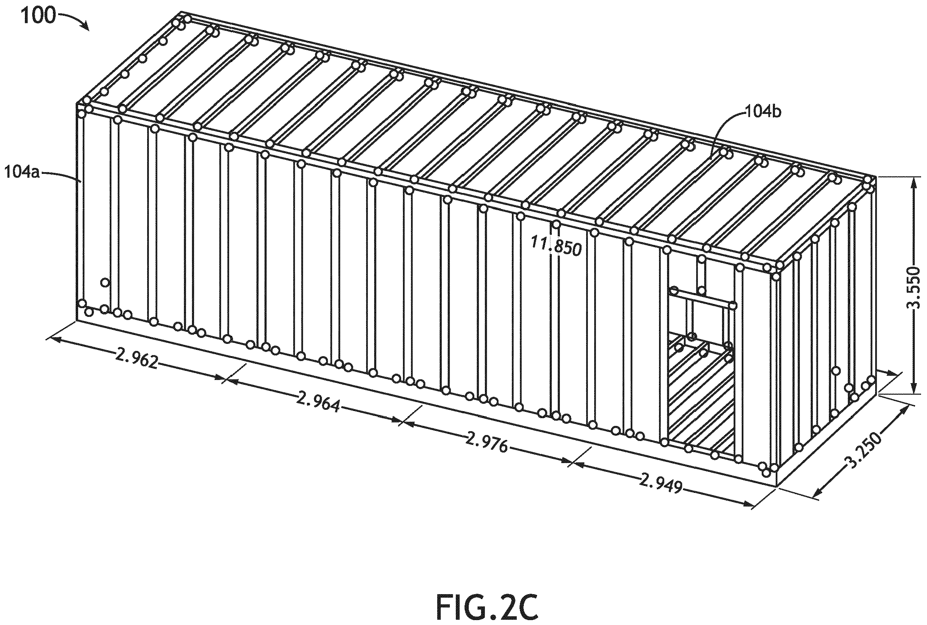

The one or more sidewall panels 106 may include one or more openings for one or more doors. For example, as shown in FIG. 1A, the front sidewall panel 106d may include an opening for a door 112. Byway of another example, as shown in FIGS. 2C-2D, the left sidewall panel 106a may include an opening for a door 112. In this regard, a user may enter the cavity 103 of the system 100 through the door 112.

The one or more sidewall panels 106 may include one or more openings for one or more vents 114. For example, as shown in FIG. 1A, the left sidewall panel 106a may include one or more openings for one or more vents 114. By way of another example, as shown in FIG. 3, the rear sidewall panel 106c may include one or more openings for one or more vents 114.

The one or more sidewall panels 106 may further include one or more lights 118 (or indicators). For example, as shown in FIG. 1A, the front sidewall panel 106d may include one or more lights 118.

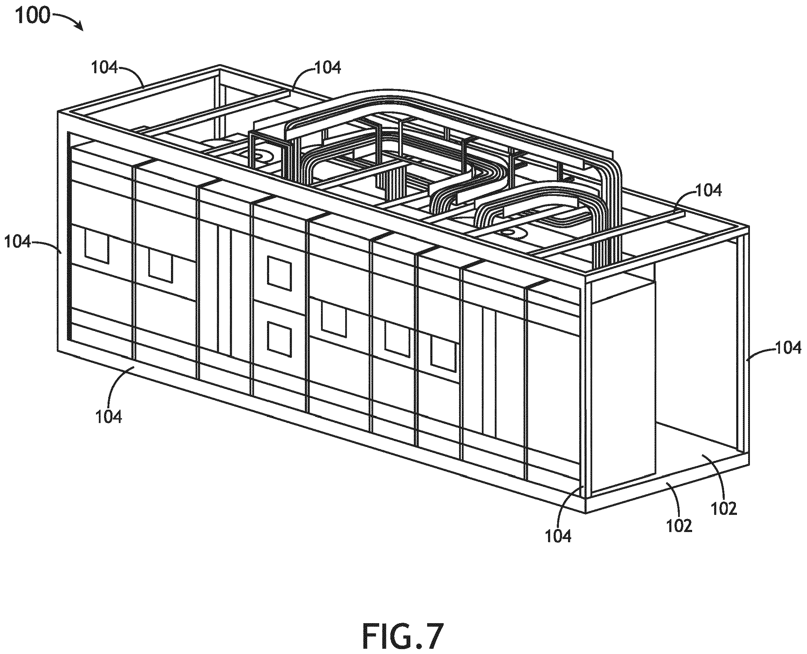

Referring to FIG. 7, in some embodiments, the one or more framing members 104 may be exposed (e.g., not coupled to one or more sidewall panels 106, roof panels 110, or the like). For example, the one or more sidewalls 102 may be formed of the one or more exposed framing members 104, such that the one or more sidewalls 102 are open. In this regard, one or more openings within the one or more sidewalls 102 may allow for wires, cables, and the like to be routed through the one or more openings. For instance, as shown in FIG. 7, the sidewall may be formed of the one or more vertical framing members and horizontal framing members, where wires/cables from the one or more pieces of equipment and/or other components of the equipment may be routed between openings formed between the adjacent horizontal framing members.

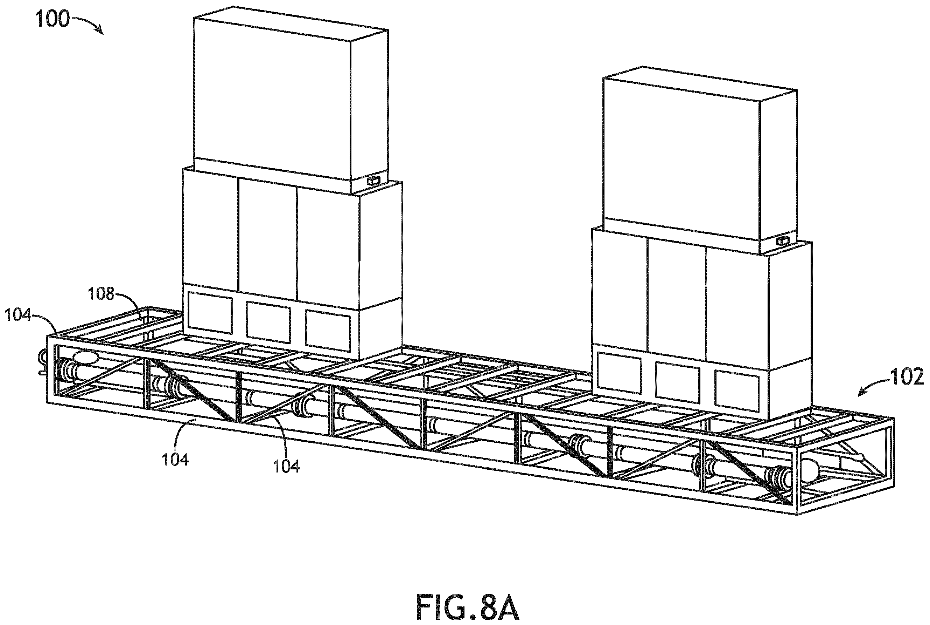

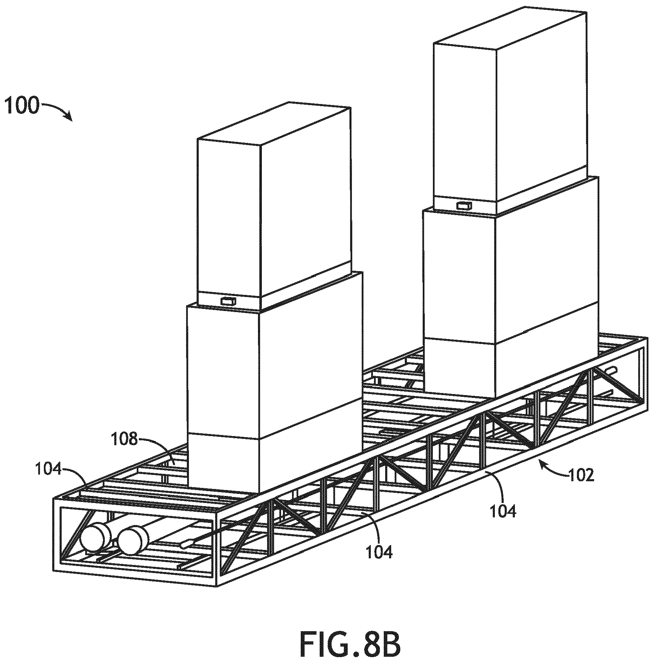

Referring to FIGS. 8A-8B, in some embodiments, the floor panel 108 may be configured to support one or more pieces of equipment installed on top of the floor panels 108. For example, the floor panel 108 may be coupled to one or more framing members 104 to define a cavity. For instance, the floor panel 108 may be coupled to one or more horizontal framing members and vertical framing members, where the respective framing members coupled to the floor panels 108 may form a platform for installing the equipment on top of such platform. Further, the floor panel 108 may be coupled to one or more exposed framing members 104 (e.g., horizontal, vertical, diagonal, or the like), such that the one or more sidewalls 102 are open (e.g., left side, right side, front, rear, and bottom sidewalls). In this regard, the one or more openings within the one or more sidewalls may allow for wires, cables, and the like to be routed through the one or more openings. In some embodiments, the one or more floor panels 108 can act as a skid (i.e., with no walls and only a floor frame with equipment on top), where the cavity within the floor panel 108 may, for example, be used for MEP installation, or the like.

As previously discussed herein, the one or more exposed framing members 104 may be formed of one or more low carbon footprint materials. For example, the one or more exposed framing members 104 may be formed of a timber material (e.g., a wood material that is suitable for construction). In one instance, the timber material may incorporate, in whole or in part, any suitable wood material (e.g., a material derived from a tree, bamboo, or another woody plant). In another instance, the timber material may incorporate, in whole or in part, a timber-based composite. In another instance, the timber material may incorporate, in whole or in part, any cut timber (or sawn timber).

Although FIGS. 1A-2 and FIGS. 8A-8B depict a specific configuration of system 100 data center accessories (e.g., doors, vents, lights, AC units/fans, and the like), it is noted that the system 100 may include any configuration of data center accessories suitable for the supporting the equipment within the cavity 103.

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader within the scope of the present invention defined by the appended claims.

## Claims

1. A modular data center system (100) comprising:
a plurality of sidewalls (102) including a plurality of framing members (104), the plurality of sidewalls (102) defining a cavity (103) configured to house one or more pieces of equipment, the plurality of sidewalls (102) comprising:
a first sidewall (102a) including a first set of framing members (104a, 104b 104c);
a second sidewall (102b) including a second set of framing members (104a, 104b 104c);
a third sidewall (102c) including a third set of framing members (104a, 104b);
a fourth sidewall (102d) including a fourth set of framing members (104a, 104b);
a fifth sidewall (102e) including a fifth set of framing members (104b);
a sixth sidewall (102f) including a sixth set of framing members (104b); and
one or more floor panels (108) configured to couple to at least one framing member (104a, 104b 104c, 104d, 104e, 104f) of the plurality of sidewalls, wherein the plurality of framing members (104) includes one of one or more vertical framing members (104a), one or more diagonal framing members (104c), or one or more horizontal framing members (104b); or
one or more sidewall panels configured to couple to at least one framing member (104a, 104b 104c, 104d, 104e, 104f) of the plurality of sidewalls, wherein the plurality of framing members (104) include at least one of one or more vertical framing members (104a) or one or more horizontal framing members (104b).

2. The system of Claim 1, wherein the first, second, third, fourth, fifth and sixth sets of framing members (104a, 104b 104c, 104d, 104e, 104f); are framing members of the plurality of framing members.

3. The system of Claim 1, wherein the plurality of framing members (104) are formed of a timber material.

4. The system of Claim 3, wherein the timber material includes a softwood timber, or a hardwood, preferably poplar.

5. The system of Claim 3, wherein the timber material includes a laminated timber, preferably glulam, or wherein the timber material includes a cross-laminated timber.

6. The system of Claim 1, 2 or 3, the one or more sidewall panels (102) including at least a first layer and a second layer, wherein the first layer is formed of a first material for thermal protection and the second layer is formed of a second material for fire resistance.

7. The system of Claim 1, 2 or 3, wherein the one or more sidewall panels include a façade (116), preferably a thermowood façade or a rock panel cladding board façade.

8. The system of Claim 1, 2 or 3, wherein the plurality of framing members (104) include one or more diagonal framing members (104c) and/or at least one base frame member (105).

9. The system of Claim 1, 2 or 3, further comprising:
one or more floor panels (110) configured to couple to at least one framing member (104a, 104b 104c, 104d, 104e, 104f) of the plurality of sidewalls (102).

10. The system of Claim 1, 2 or 3, further comprising:
one or more roof panels configured to couple to at least one framing member of the plurality of sidewalls.

11. The system of Claim 1, 2 or 3, wherein the one or more pieces of data center equipment comprise at least one of:
one or more low voltage switch boards, one or more air conditioning units, one or more liquid cooling units, one or more uninterruptible power supplies, one or more server racks, one or more batteries, one or more fuel cells, one or more electrolysers, or one or more power converters.

12. A modular data center system (100) comprising:
a plurality of framing members (104), the plurality of framing members (104) including one of one or more vertical framing members (104a), one or more diagonal framing members (104c), or one or more horizontal framing members (104b); and
one or more floor panels (108) configured to couple to at least one framing member (104a, 104b 104c, 104d, 104e, 104f) of the plurality of framing members (104) to define a cavity (103), the one or more floor panels (108) configured to support one or more pieces of equipment.

13. The system of Claim 12, wherein the one or more floor panels (108) are configured to operate as a skid.

14. The system of Claim 12, wherein the cavity within the one or more floor panels (108) is available for use in MEP installation.
